# EUROPÄISCHE PATENTSCHRIFT

(11) **EP 2 350 173 B1**
(45) Veröffentlichungstag und Bekanntmachung des Hinweises auf die Patenterteilung: **04.12.2013**
(21) Anmeldenummer: 09748295.4
(22) Anmeldetag: 26.10.2009
(51) Int. Cl.: C08J 3/24, C08L 83/04, C08K 5/00, C08K 5/56, H01L 23/29

(54) **VERFAHREN ZUR HERSTELLUNG VON SILICONLINSEN FÜR LEDs AUS DURCH LICHT VERNETZBAREN SILICONMISCHUNGEN**
METHOD FOR PRODUCING SILICONE LENSES FOR LED FROM LIGHT-CURABLE SILICONE MIXTURES
PROCÉDÉ POUR PRODUIRE DES LENTILLES À DEL EN SILICONE À PARTIR DE MÉLANGES DE SILICONE PHOTORÉTICULABLES

(30) Priorität: 30.10.2008 DE 102008043316
(43) Veröffentlichungstag der Anmeldung: 03.08.2011
(73) Patentinhaber: Wacker Chemie AG, 81737 München (DE)
(72) Erfinder: ANGERMAIER, Klaus, 81825 München (DE); MÜLLER, Philipp, 84489 Burghausen (DE)
(74) Vertreter: Fritz, Helmut
(86) Internationale Anmeldenummer: PCT/EP2009/064079
(87) Internationale Veröffentlichungsnummer: WO 2010/049388

(56) Entgegenhaltungen:
- EP-A- 0 153 700
- WO-A-02/00561
- DE-A1-102004 036 573
- JP-A- 2 165 932
- US-A- 4 587 137
- US-A- 4 670 531
- US-A- 5 982 041
- US-A- 6 039 831
- US-A- 6 046 250
- US-A1- 2002 142 174
- US-A1- 2003 027 003
- US-A1- 2006 105 481
- US-A1- 2007 141 739
- US-A1- 2007 170 454
- US-B1- 6 730 933
- "Silicone materials development for LED packaging", LEDS MAGAZINE, March 2006 (2006-03),
- 'Molding (process)', [Online] Gefunden im Internet: <URL:http://en.wikipedia.org/wiki/Molding_( process)> [gefunden am 2012-10-08]

## Beschreibung

Die Erfindung betrifft ein Verfahren zur Herstellung von Siliconformkörpern aus durch Licht vernetzbaren Siliconmischungen durch Vorvernetzen der geformten Siliconmischungen mit Licht.

In Glob-Top Anwendungen werden einzelne Bauelemente in elektronischen Geräten durch Beschichten geschützt. Das Design bzw. die Anordnung der Baugruppen auf der Leiterplatte erlaubt es nicht, dass die vom Silicon nach dem Auftragen benetzte Fläche im weiteren Verlauf der Verarbeitung durch Verlauf ausgedehnt wird. Die Funktionalität der benachbarten Bauteile würde durch diese Ausdehnung gestört werden.

In vielen Fällen werden Formkörper aus Silicon durch Spritzgussverfahren hergestellt. Dies wäre bei der Beschichtung von Leiterplatten nicht möglich, da ein Metallwerkzeug in welches eine Leiterplatte eingelegt werden könnte, nicht hergestellt werden kann.

WO 2006/010763 A1 beschreibt die Verwendung von lichtaktivierbaren Siliconmischungen zur Verwendung in Spritzgussprozessen und für dickwandige Beschichtungen. Die lichtaktivierbare Siliconmischung wird bestrahlt, anschließend in einen Formgebungsprozess überführt und dann ohne weitere Bestrahlung ausgehärtet.

Feuchtigkeitsvernetzende Siliconmassen sind zwar standfest, jedoch kommen sie für viele elektronische Anwendungen nicht in Frage, da sie zur Vernetzung unerwünschte Luftfeuchtigkeit benötigen und flüchtige Verbindungen freisetzen, z.B. Alkohole, Essigsäure und Oxime. Für Formteile ist der starke Schrumpf inakzeptabel.

Gegenstand der Erfindung ist ein Verfahren zur Herstellung von Siliconformkörpern, wobei das Verfahren die Herstellung von Linsen für LEDs betrifft, bei dem ohne die Verwendung eines äußeren, die geometrische Form gebenden Werkzeugs
1) eine durch Licht vernetzbare Siliconmischung zu Linsen für LEDS geformt wird,
2) danach die geformte Siliconmischung mit Licht von 200 bis 500 nm bestrahlt wird, um diese so vorzuvernetzten, dass diese ihre Form bei einer Temperatur T beibehält und
3) danach die geformte und bestrahlte Siliconmischung bei der Temperatur T thermisch zu Formkörpern ausgehärtet wird.

Die Formkörper aus Silicon können ohne die Verwendung wesentlich teuerer Spritzgussverfahren hergestellt werden. Es fallen geringere Handlingskosten, geringere Anlagenkosten und keine Nachbearbeitung an. Das Verfahren ist sowohl bei kleinen Fertigungsserien als auch bei Großserien einsetzbar.
Eine für Spritzgussverfahren typischerweise verwendete Metallform ist für die Herstellung von dicken Beschichtungen nicht notwendig.

Im Vergleich zu konventionellen, unter Verwendung von Dispenstechnologie verarbeitbaren RTV Siliconen erlaubt die lichtinduzierte Vorhärtung das Konservieren der äußeren Geometrie des Siliconteils auch während des Aufwärmens.

Durch die Verwendung einer unter Lichteinfluss aktivierbaren oder aushärtenden Siliconmischung wird die Form der Siliconmischung, die diese nach dem Formen, einschließlich Auftragen, wie Dispensen, Spritzen, Rakeln einnimmt, durch Belichtung konserviert. Durch das Bestrahlen wird die Siliconmischung teilweise vernetzt und so ein hinreichend stabiles Netzwerk ausgebildet.
Die endgültige Aushärtung unter voller Entwicklung aller Materialeigenschaften, wie Härte, Festigkeit, Haftung, wird in einem anschließenden thermischen Härtungsschritt erreicht.

Ein Verzichten auf die thermische Nachhärtung und alleinige Aushärtung durch den Einfluss von Licht wäre nicht möglich, da sich dann bestimmte Eigenschaften des Materialprofils wie z.B. Haftungseigenschaften nicht ausbilden würden.

Mit konventionellen, nicht durch Licht aushärtenden additionsvernetzbaren Siliconmassen würde die äußere Form des geformten Silicons mit steigender Temperatur durch die Viskositätsänderung zerstört werden; erst die Verwendung von durch Licht vernetzbaren Siliconmischungen macht dieses Verfahren möglich, da die ursprüngliche äußere Geometrie durch die anfängliche, durch Licht initiierte Vorhärtung auch während der Erwärmung konserviert wird.

Das Formen findet bevorzugt bei mindestens 0°C besonders bevorzugt mindestens 10°C, insbesondere mindestens 15°C und bevorzugt bei höchstens 50°C, besonders bevorzugt höchstens 35°C, insbesondere höchstens 25°C statt.

Die Bestrahlung der geformten Siliconmischung mit Licht dauert bevorzugt mindestens 1 Sekunde, besonders bevorzugt mindestens 5 Sekunden und bevorzugt höchstens 500 Sekunden, besonders bevorzugt höchstens 100 Sekunden.
Durch die einsetzende Hydrosilylierungsreaktion beginnt die Vernetzung der Siliconmischung - sie geliert.

Die geformte und bestrahlte Siliconmischung wird nach der Bestrahlung mit Licht vorzugsweise nach höchstens 1 Stunde, besonders bevorzugt nach höchstens 10 Minuten, insbesondere höchstens nach 1 Minute erwärmt, um sie zu Formkörpern auszuhärten.

Die Temperatur T beträgt vorzugsweise mindestens 80°C besonders bevorzugt mindestens 100°C, insbesondere mindestens 120°C und bevorzugt bei höchstens 250°C, besonders bevorzugt höchstens 200°C, insbesondere höchstens 160°C.

Die Dauer der Aushärtung bei der Temperatur T beträgt bevorzugt mindestens 30 Sekunden, besonders bevorzugt mindestens 1 Minute und bevorzugt höchstens 60 Minuten, besonders bevorzugt höchstens 10 Minuten.

Der Formkörper härtet dabei vollständig aus und bildet sein vollständiges Eigenschaftsprofil aus. Während der gesamten Erwärmung ändert die geformte Siliconmischung ihre geometrische Form nicht.

Die Siliconmischung weist vorzugsweise eine Viskosität [D = 0,5 / 25°C] von mindestens 10000 mPas, insbesondere mindestens 20000 mPas, vorzugsweise höchstens 2000000 mPas, insbesondere höchstens 100000 mPas auf.

Bei der durch Licht von 200 bis 500 nm vernetzbaren Siliconmischung kann es sich um eine aus 2 Komponenten oder aus nur 1 Komponente aufgebaute Mischung handeln. Vorzugsweise enthält die Siliconmischung:
(A) mindestens zwei Alkenylgruppen pro Molekül enthaltendes Polyorganosiloxan mit einer Viskosität bei 25°C von 0,1 bis 500 000 Pa·s,
(B) mindestens zwei SiH-Funktionen pro Molekül enthaltende Organosiliciumverbindung und
(C) durch Licht von 200 bis 500 nm aktivierbaren Katalysator der Platingruppe.

Die Zusammensetzung des Alkenylgruppen enthaltenden Polyorganosiloxans (A) entspricht vorzugsweise der durchschnittlichen allgemeinen Formel (1)

R¹ₓR²_{y}SiO_{(4-x-y)/2} (1) ,

in der
- **R¹**: einen einwertigen, gegebenenfalls halogen- oder cyanosubstituierten, gegebenenfalls über eine organische zweiwertige Gruppe an Silicium gebundenen C₁-C₁₀-Kohlenwasserstoffrest, der aliphatische Kohlenstoff-Kohlenstoff Mehrfachbindungen enthält,
- **R²**: einen einwertigen, gegebenenfalls halogen- oder cyanosubstituierten, über SiC-gebundenen C₁-C₁₀-Kohlenwasserstoffrest, der frei ist von aliphatischen Kohlenstoff-Kohlenstoff Mehrfachbindungen
- **x**: eine solche nichtnegative Zahl, dass mindestens zwei Reste **R¹** in jedem Molekül vorhanden sind, und
- **y**: eine nicht negative Zahl, so daß **(x+y)** im Bereich von 1,8 bis 2,5 liegt, bedeuten.

Die Alkenylgruppen **R¹** sind einer Anlagerungsreaktion mit einem SiH-funktionellen Vernetzungsmittel zugänglich. Üblicherweise werden Alkenylgruppen mit 2 bis 6 Kohlenstoffatomen, wie Vinyl, Allyl, Methallyl, 1-Propenyl, 5-Hexenyl, Ethinyl, Butadienyl, Hexadienyl, Cyclopentenyl, Cyclopentadienyl, Cyclohexenyl, vorzugsweise Vinyl und Allyl, verwendet.

Organische zweiwertige Gruppen, über die die Alkenylgruppen **R¹** an Silicium der Polymerkette gebunden sein können, bestehen beispielsweise aus Oxyalkyleneinheiten, wie solche der allgemeinen Formel (2)

-(O)ₘ[(CH₂)ₙO]_{O}- (2),

in der
- **m**: die Werte 0 oder 1, insbesondere 0,
- **n**: Werte von 1 bis 4, insbesondere 1 oder 2 und
- **o**: Werte von 1 bis 20, insbesondere von 1 bis 5 bedeuten.

Die Oxyalkyleneinheiten der allgemeinen Formel (10) sind links an ein Siliciumatom gebunden.

Die Reste **R¹** können in jeder Position der Polymerkette, insbesondere an den endständigen Siliciumatomen, gebunden sein.

Beispiele für unsubstituierte Reste **R²** sind Alkylreste, wie der Methyl-, Ethyl-, n-Propyl-, iso-Propyl-, n-Butyl-, iso-Butyl-, tert.-Butyl-, n-Pentyl-, iso-Pentyl-, neo-Pentyl-, tert.-Pentylrest, Hexylreste, wie der n-Hexylrest, Heptylreste, wie der n-Heptylrest, Octylreste, wie der n-Octylrest und iso-Octylreste, wie der 2,2,4-Trimethylpentylrest, Nonylreste, wie der n-Nonylrest, Decylreste, wie der n-Decylrest; Alkenylreste, wie der Vinyl-, Allyl-, n-5-Hexenyl-, 4-Vinylcyclohexyl- und der 3-Norbornenylrest; Cycloalkylreste, wie Cyclopentyl-, Cyclohexyl-, 4-Ethylcyclohexyl-, Cycloheptylreste, Norbornylreste und Methylcyclohexylreste; Arylreste, wie der Phenyl-, Biphenylyl-, Naphthylrest; Alkarylreste, wie o-, m-, p-Tolylreste und Ethylphenylreste; Aralkylreste, wie der Benzylrest, der alpha- und der ß-Phenylethylrest.

Beispiele für substituierte Kohlenwasserstoffreste als Reste **R²** sind halogenierte Kohlenwasserstoffe, wie der Chlorethyl-, 3-Chlorpropyl-, 3-Brompropyl, 3,3,3-Trifluorpropyl und 5, 5, 5, 4, 4, 3, 3-Heptafluorpentylrest sowie der Chlorphenyl-, Dichlorphenyl" und Trifluortolylrest.

**R²** weist vorzugsweise 1 bis 6 Kohlenstoffatome auf. Insbesondere bevorzugt sind Methyl und Phenyl.

Bestandteil (A) kann auch eine Mischung verschiedener Alkenylgruppen enthaltender Polyorganosiloxane sein, die sich beispielsweise im Alkenylgruppengehalt, der Art der Alkenylgruppe oder strukturell unterscheiden.

Die Struktur der Alkenylgruppen enthaltenden Polyorganosiloxane (A) kann linear, cyclisch oder auch verzweigt sein. Der Gehalt an zu verzweigten Polyorganosiloxanen führenden tris- und/oder tetrafunktionellen Einheiten, ist typischerweise sehr gering, vorzugsweise höchstens 20 Mol-%, insbesondere höchstens 0,1 Mol-%.

Besonders bevorzugt ist die Verwendung Vinylgruppen enthaltender Polydimethylsiloxane, deren Moleküle der allgemeinen Formel (3)

(ViMe₂SiO_{1/2})₂(ViMeSiO)ₚ(Me₂SiO)_{q} (3),

entsprechen, wobei die nichtnegativen ganzen Zahlen p und q folgende Relationen erfüllen: p≥0, 50<(p+q)<20000, vorzugsweise 200<(p+q)<1000, und 0<(p+l)/(p+q)<0.2.

Die Viskosität des Polyorganosiloxans (A) beträgt bei 25°C vorzugsweise 0,5 bis 100000 Pa·s, insbesondere 1 bis 2000 Pa·s.

Die mindestens zwei SiH-Funktionen pro Molekül enthaltende Organosiliciumverbindung (B), besitzt vorzugsweise eine Zusammensetzung der durchschnittlichen allgemeinen Formel (4)

HₐR³_{b}SiO_{(4-a-b)/2} (4),

in der
- **R³**: einen einwertigen, gegebenenfalls halogen- oder cyanosubstituierten, über SiC-gebundenen C₁-C₁₈-Kohlenwasserstoffrest, der frei ist von aliphatischen Kohlenstoff-Kohlenstoff Mehrfachbindungen und
**a** und **b** nichtnegative ganze Zahlen sind,
mit der Maßgabe, dass 0.5<**(a+b)**<3,0 und 0<**a**<2, und dass mindestens zwei siliciumgebundene Wasserstoffatome pro Molekül vorhanden sind.

Beispiele für **R³** sind die für **R²** angegebenen Reste. **R³** weist vorzugsweise 1 bis 6 Kohlenstoffatome auf. Insbesondere bevorzugt sind Methyl und Phenyl.

Bevorzugt ist die Verwendung einer drei oder mehr SiH-Bindungen pro Molekül enthaltenden Organosiliciumverbindung (B). Bei Verwendung einer nur zwei SiH-Bindungen pro Molekül aufweisenden Organosiliciumverbindung (B) empfiehlt sich die Verwendung eines Polyorganosiloxans (A), das über mindestens drei Alkenylgruppen pro Molekül verfügt.

Der Wasserstoffgehalt der Organosiliciumverbindung (B), welcher sich ausschließlich auf die direkt an Siliciumatome gebundenen Wasserstoffatome bezieht, liegt vorzugsweise im Bereich von 0,002 bis 1,7 Gew.-% Wasserstoff, vorzugsweise von 0,1 bis 1,7 Gew.-% Wasserstoff.

Die Organosiliciumverbindung (B) enthält vorzugsweise mindestens drei und höchstens 600 Siliciumatome pro Molekül. Bevorzugt ist die Verwendung von Organosiliciumverbindung (B), die 4 bis 200 Siliciumatome pro Molekül enthält.

Die Struktur der Organosiliciumverbindung (B) kann linear, verzweigt, cyclisch oder netzwerkartig sein.

Besonders bevorzugte Organosiliciumverbindungen (B) sind lineare Polyorganosiloxane der allgemeinen Formel (5)

(HR⁴₂SiO_{1/2})_{c}(R⁴₃SiO_{1/2})_{d}(HR⁴SiO_{2/2})ₑ(R⁴₂SiO_{2/2})_{f} (5),

wobei
**R⁴** die Bedeutungen von **R³** hat und
die nichtnegativen ganzen Zahlen **c, d, e** und **f** folgende Relationen erfüllen: **(c+d)=2, (c+e)**>2, 5<**(e+f)**<200 und 1<**e**/(**e +f**) <0,1.

Die SiH-funktionelle Organosiliciumverbindung (B) ist vorzugsweise in einer solchen Menge in der vernetzbaren Siliconmasse enthalten, dass das Molverhältnis von SiH-Gruppen zu Alkenylgruppen bei 0,5 bis 5, insbesondere bei 1,0 bis 3,0 liegt.

Als Katalysator (C) können alle bekannten Katalysatoren der Platingruppe eingesetzt werden, welche die bei der Vernetzung von additionsvernetzenden Siliconmassen ablaufenden Hydrosilylierungsreaktionen katalysieren und durch Licht von 200 bis 500 nm aktivierbar sind.

Der Katalysator (C) enthält ein mindestens ein Metall oder eine Verbindung von Platin, Rhodium, Palladium, Ruthenium und Iridium, vorzugsweise Platin.

Besonders geeignete Katalysatoren (C) sind Cyclopentadienyl-Komplexe des Platin, vorzugsweise der allgemeinen Formel (6) 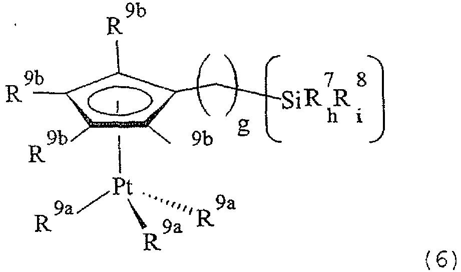 wobei
g = 1 bis 8,
h = 0 bis 2,
**i** = 1 bis 3,
**R⁷** unabhängig voneinander, gleich oder verschieden einen monovalenten, unsubstituierten oder substituierten, linearen, cyclischen oder verzweigten, aliphatisch gesättigte oder ungesättigte oder aromatisch ungesättigte Reste enthaltenden Kohlenwasserstoffrest mit 1 bis 30 Kohlenstoffatomen, in dem einzelne Kohlenstoffatome durch O-, N-, S- oder P-Atome ersetzt sein können,
**R⁸** unabhängig voneinander, gleiche oder verschiedene hydrolysierbare funktionelle Gruppen, ausgewählt aus der Gruppe enthaltend
Carboxy -O-C(O)R¹⁰,
Oxim -O-N=CR¹⁰₂,
Alkoxy -OR¹⁰,
Alkenyloxy -O-R¹²
Amid -NR¹⁰-C(O)R¹¹,
Amin -NR¹⁰R¹¹,
Aminoxy -O-NR¹⁰R¹¹, mit
R¹⁰ unabhängig voneinander, gleich oder verschieden H, Alkyl, Aryl, Arylalkyl, Alkylaryl,
R¹¹ unabhängig voneinander, gleich oder verschieden Alkyl, Acryl, Arylalkyl, Alkylaryl,
R¹² einen linearen oder verzweigten, aliphatisch ungesättigten organischen Rest,
R^{9a} unabhängig voneinander, gleich oder verschieden Alkyl, Aryl, Arylalkyl, Alkylaryl mit 1 bis 30 Kohlenstoffatomen, wobei die Wasserstoffe durch -Hal oder -SiR⁹₃ substituiert sein können, mit
R⁹ unabhängig voneinander, gleich oder verschieden einen monovalenten, unsubstituierten oder substituierten, linearen, cyclischen oder verzweigten Kohlenwasserstoffrest,
R^{9b} unabhängig voneinander, gleich oder verschieden Wasserstoff oder einen monovalenten, unsubstituierten oder substituierten, linearen oder verzweigten, aliphatisch gesättigte oder ungesättigte oder aromatisch ungesättigte Reste enthaltenden Kohlenwasserstoffrest mit 1 bis 30 Kohlenstoffatomen, in dem einzelne Kohlenstoffatome durch O-, N-, S- oder P-Atome ersetzt sein können und die mit dem Cyclopentadienylrest annelierte Ringe bilden können, bedeuten.

Bevorzugte Reste R⁷ sind lineare gesättigte
Kohlenwasserstoffreste mit 1 bis 8 Kohlenstoffatomen. Weiterhin bevorzugt ist der Phenylrest.

Bevorzugte Reste R⁸ sind Methoxy-, Ethoxy-, Acetoxy- und 2-Methoxyethoxy-Gruppen.

Bevorzugte Reste R^{9a} sind lineare und verzweigte, gegebenenfalls substituierte Alkylreste wie Methyl-, Ethyl-, Propyl- oder Butylreste.

Bevorzugte Reste R^{9b} sind lineare und verzweigte, gegebenenfalls substituierte Alkylreste wie Methyl-, Ethyl-, Propyl- oder Butylreste. Weiterhin bevorzugt sind gegebenenfalls weiter substituierte annelierte Ringe wie zum Beispiel der Indenyl- oder der Fluorenylrest.

Besonders bevorzugt als Katalysator (C) ist MeCp(PtMe₃).

Katalysator (C) kann in jeder beliebigen Form eingesetzt werden, beispielsweise auch in Form von Hydrosilylierungskatalysator enthaltenden Mikrokapseln, oder Organopolysiloxanpartikeln, wie beschrieben in EP-A-1006147.

Der Gehalt an Hydrosilylierungskatalysatoren (C) wird vorzugsweise so gewählt, dass die Siliconmischung einen Gehalt an Metall der Platingruppe von 0,1-200 ppm, bevorzugt von 0,5-40 ppm besitzt.

Die Siliconmischung ist bevorzugt transparent und frei von Licht absorbierenden Füllstoffen.

Die Siliconmischung kann jedoch auch Füllstoff (D) enthalten. Beispiele für sind nicht verstärkende Füllstoffe (D) sind Füllstoffe mit einer BET-Oberfläche von bis zu 50 m²/g, wie Quarz, Diatomeenerde, Calciumsilikat, Zirkoniumsilikat, Zeolithe, Metalloxidpulver, wie Aluminium-, Titan-, Eisen-, oder Zinkoxide bzw, deren Mischoxide, Bariumsulfat, Calciumcarbonat, Gips, Siliciumnitrid, Siliciumcarbid, Bornitrid, Glas- und Kunststoffpulver. Verstärkende Füllstoffe, also Füllstoffe mit einer BET-Oberfläche von mindestens 50 m²/g, sind beispielsweise pyrogen hergestellte Kieselsäure, gefällte Kieselsäure, Ruß, wie Furnace- und Acetylenruß und Silicium-Aluminium-Mischoxide großer BET-Oberfläche. Faserförmige Füllstoffe sind beispielsweise Asbest sowie Kunststoffasern. Die genannten Füllstoffe können hydrophobiert sein, beispielsweise durch die Behandlung mit Organosilanen bzw, -siloxanen oder durch Verätherung von Hydroxylgruppen zu Alkoxygruppen. Es kann eine Art von Füllstoff, es kann auch ein Gemisch von mindestens zwei Füllstoffen eingesetzt werden.

Wenn die Siliconmischungen Füllstoff (D) enthalten, beträgt dessen Anteil vorzugsweise 2 bis 60 Gew.-%, insbesondere 5 bis 50 Gew.-%.

Die Siliconmischungen können als Bestandteil (E) weitere Zusätze zu einem Anteil von bis zu 70 Gew.-%, vorzugsweise 0,0001 bis 40 Gel.-%, enthalten. Diese Zusätze können z.B. harzartige Polyorganosiloxane, die von den Diorganopolysiloxanen (A) und (B) verschieden sind, Dispergierhilfsmittel, Lösungsmittel, Haftvermittler, Pigmente, Farbstoffe, Weichmacher, organische Polymere, Hitzestabilisatoren usw. sein. Des Weiteren können als Bestandteil (E) thixotropierende Bestandteile, wie hochdisperse Kieselsäure oder andere handelsübliche Thixotropieadditive enthalten sein. Zusätzlich können auch als Kettenverlängerer Siloxane der Formel HSi(CH₃)₂-[O-Si(CH₃)₂]_{w}-H vorhanden sein, wobei w Werte von 1 bis 1000 bedeutet.
Enthalten sein können des Weiteren Zusätze (E), die der gezielten Einstellung der Verarbeitungszeit, Anspringtemperatur und Vernetzungsgeschwindigkeit der Siliconmischung dienen.

Diese Inhibitoren und Stabilisatoren sind auf dem Gebiet der vernetzenden Massen sehr gut bekannt.
Zusätzlich können auch Additive hinzugefügt werden, die den Druckverformungsrest verbessern. Zusätzlich können auch Hohlkörper hinzugefügt werden. Zusätzlich können auch Treibmittel zur Erzeugung von Schäumen hinzugefügt werden. Zusätzlich können auch nicht vinylfunktionalisierte Polydiorganosiloxane hinzugefügt werden.

Die Compoundierung der Siliconmischung erfolgt durch Mischen der oben aufgeführten Komponenten in beliebiger Reihenfolge.

Alle vorstehenden Symbole der vorstehenden Formeln weisen ihre Bedeutungen jeweils unabhängig voneinander auf. In allen Formeln ist das Siliciumatom vierwertig.

In den nachfolgenden Beispielen sind, falls jeweils nicht anders angegeben, alle Mengen- und Prozentangaben auf das Gewicht bezogen, alle Drücke 0,10 MPa (abs.) und alle Temperaturen 20°C.

### Beispiele

### Siliconmischung A

| | Teile |
|---|---|
| Vinylpolymer 1000 | 90 |
| HDK | 3 |
| Glymo | 1 |
| H-Siloxan | 6 |
| Platinkatalysator | 0,01 |

Dabei gilt:
- für Vinylpolymer 1000: ViMe₂SiO-(Me₂SiO)ₛ-SiMe₂Vi mit s = 200
- für Glymo: Gamma-Glycidoxypropyltrimethoxysilan
- für H-Siloxan: Me₃SiO-(MeHSiO)ₜ-(Me₂SiO)ᵤ-SiMe₃ mit t+u = 50
- für HDK: pyrogene Kieselsäure mit einer Oberfläche nach BET von 150 m²/g ()
- für Platinkatalysator: MeCp(PtMe₃)

### Materialeigenschaften

| | Wert [mPas] |
|---|---|
| Viskosität [D = 0,5 / 25°C] | 50 000 |
| Viskosität [D = 0,5 / 100°C] | 22 000 |

Ein elektronisches Bauteil der Größe 10 x 10 mm wird mit der oben genannten Siliconmischung A vollständig bedeckt. Das Silicon bedeckt nach dem Ausbringen eine Fläche von 3,5 cm².

Anschließend wird die Mischung für 1 Sekunde mit einer Leistung von 200 mW/cm² mit einer UV-Lampe belichtet. Nach weiteren 30 Sekunden wird das Bauteil mit dem aktivierten Silicon für 5 min bei 140°C ausgehärtet. Unter diesen Bedingungen bildet das Silicon Haftung zur Leiterplatte aus. Während des Erwärmens verändert das Silicon seine Form nicht, die benetzte Fläche vergrößert sich nicht weiter.

Bei einer vergleichbar formulierten Siliconmischung, jedoch nicht durch Licht und nur durch Temperatur aktivierbar, wird zwar nach dem Auftragen ebenfalls eine Fläche von 3,5 cm² bedeckt, durch das Erwärmen auf Zieltemperatur sinkt die Viskosität jedoch ab, so dass die vom Silicon bedeckte Fläche nach dem Aushärten deutlich größer als 3,5 cm² wird.

## Patentansprüche

1. Verfahren zur Herstellung von Siliconformkörpern, wobei das Verfahren die Herstellung von Linsen für LEDs betrifft,
bei dem ohne die Verwendung eines äußeren, die geometrische Form gebenden Werkzeugs
1) eine durch Licht vernetzbare Siliconmischung zu Linsen für LEDs geformt wird,
2) danach die geformte Siliconmischung mit Licht von 200 bis 500 nm bestrahlt wird, um diese so vorzuvernetzen, dass diese ihre Form bei einer Temperatur T beibehält und
3) danach die geformte und bestrahlte Siliconmischung bei der Temperatur T thermisch zu Formkörpern ausgehärtet wird.

2. Verfahren nach Anspruch 1, bei dem das Formen bei 10°C bis 35°C stattfindet.

3. Verfahren nach Anspruch 1 oder 2, bei dem die Temperatur T 100°C bis 180°C beträgt.

4. Verfahren nach Anspruch 1 bis 3, bei dem die Siliconmischung
(A) mindestens zwei Alkenylgruppen pro Molekül enthaltendes Polyorganosiloxan mit einer Viskosität bei 25°C von 0,1 bis 500 000 Pa·s,
(B) mindestens zwei SiH-Funktionen pro Molekül enthaltende Organosiliciumverbindung und
(C) durch Licht von 200 bis 500 nm aktivierbaren Katalysator der Platingruppe enthält.

## Claims

1. Process for producing silicone moldings where the process relates to the production of lenses for LEDs and does not use any exterior mold which prescribes the geometric shape, by
1) molding a silicone mixture that can be crosslinked by light to give lenses for LEDs,
2) then irradiating the molded silicone mixture with light of from 200 to 500 nm in order to precrosslink the mixture, in such a way that it retains its shape at a temperature T, and
3) then hardening the molded and irradiated silicone mixture thermally at the temperature T to give moldings.

2. Process according to Claim 1, in which the molding process takes place at from 10°C to 35°C.

3. Process according to Claim 1 or 2, in which the temperature T is from 100°C to 180°C.

4. Process according to Claims 1 to 3, in which the silicone mixture comprises
(A) polyorganosiloxane which has a viscosity at 25°C of from 0.1 to 500 000 Pa·s and which comprises at least two alkenyl groups per molecule,
(B) organosilicon compound comprising at least two SiH functions per molecule, and
(C) platinum-group catalyst activatable by light of from 200 to 500 nm.

## Revendications

1. Procédé pour la fabrication de corps façonnés en silicone, le procédé concernant la fabrication de lentilles pour DEL, dans lequel, sans utiliser d'outil externe, conférant la forme géométrique,
1) un mélange de silicone réticulable par la lumière est façonné en lentilles pour DEL,
2) le mélange de silicone façonné est ensuite irradié par une lumière de 200 à 500 nm, afin de le préréticuler de manière telle que celui-ci conserve sa forme à une température T et
3) le mélange de silicone façonné et irradié est ensuite durci thermiquement à la température T en corps façonnés.

2. Procédé selon la revendication 1, dans lequel le façonnage a lieu à 10°C jusqu'à 35°C.

3. Procédé selon la revendication 1 ou 2, dans lequel la température T vaut 100°C à 180°C.

4. Procédé selon les revendications 1 à 3, dans lequel le mélange de silicone contient
(A) un polyorganosiloxane contenant au moins deux groupes alcényle par molécule, présentant une viscosité à 25°C de 0,1 à 500 000 Pa.s,
(B) un composé organosilicié contenant au moins deux fonctions SiH par molécule et
(C) un catalyseur du groupe du platine, activable par une lumière de 200 à 500 nm.
